# EUROPÄISCHE PATENTANMELDUNG

(11) **EP 3 537 856 A2**
(43) Veröffentlichungstag der Anmeldung: **11.09.2019**
(21) Anmeldenummer: 19155648.9
(22) Anmeldetag: 06.02.2019
(51) Int. Cl.: H05K 3/36, H05K 1/14, H01R 12/52

(54) **LEITERPLATTENANORDNUNG MIT ABSTANDSBOLZEN ZUR DATENÜBERTRAGUNG ZWISCHEN EINZELNEN LEITERPLATTEN**

(30) Priorität: 15.02.2018 DE 102018202312
(71) Anmelder: Messtec Power Converter GmbH, 82377 Penzberg (DE)
(72) Erfinder: Walter, Oskar, Dipl. Ing (FH), 80639 München (DE)
(74) Vertreter: Körfer, Thomas

(57) **Zusammenfassung**

Eine Leiterplattenanordnung (300) besteht aus mindestens zwei Leiterplatten (310, 320), welche mittels elektrischleitenden Abstandsbolzen (330, 340) voneinander beabstandet und elektrisch miteinander verbunden sind. Die Leiterplattenanordnung (300) weist einen ersten Abstandsbolzen (330) und mindestens einen zweiten (340) Abstandsbolzen zur Herstellung einer Datenübertragungsverbindung zwischen einer ersten Leiterplatte (310) und mindestens einer zweiten Leiterplatte (320) auf.

## Beschreibung

Die Erfindung betrifft eine Leiterplattenanordnung bestehend aus mindestens zwei Abstandsbolzen zur Beabstandung von und zur Datenübertragung zwischen zumindest zwei Leiterplatten.

Die Kommunikation eines Computers mit Peripheriegeräten, aber auch die Kommunikation innerhalb eines Gerätes, beispielsweise zwischen einzelnen Baugruppen bzw. einzelnen Leiterplatten, welche diese Baugruppen beinhalten, erfordert den Austausch elektrischer Signale respektive den Austausch von Daten und erfolgt im Allgemeinen über Bus-Systeme oder Punkt zu Punkt Verbindungen.

Die Datenkommunikationsverbindung innerhalb eines Gerätes, beispielsweise zwischen einzelnen Leiterplatten, erfolgt meist leitungsgebunden, indem auf den einzelnen Leiterplatten Klemmen montiert sind, welche durch Leitungen miteinander verbunden sind oder auch mittels Steckverbindern, die jeweils auf den einzelnen Leiterplatten angebracht sind und durch Zusammenstecken der Leiterplatten eine elektrische Verbindung der einzelnen Leiterplatten untereinander herstellen. Somit wird eine Signalübertragung respektive ein Datenaustausch zwischen den einzelnen Leiterplatten möglich. Zusätzlich zur Datenkommunikationsverbindung werden auch Masseverbindungen und Versorgungsspannungsverbindungen mittels Klemmen respektive Steckverbindern zwischen einzelnen Leiterplatten realisiert. Hierzu sei z.B. auf die US 4,733,461 verwiesen.

Die Montage von Klemmen bzw. Steckverbindern auf den Leiterplatten muss zu einem großen Teil manuell durchgeführt werden, was den Fertigungsaufwand erhöht und somit auch die Fertigungskosten. Des Weiteren haben Klemmen, respektive Steckverbinder auch einen hohen Platzbedarf, was die Baugröße erhöht. Auch führt eine große Anzahl von benötigten Klemmen und Steckverbindern zu höheren Materialkosten.

Das Dokument DE 38 13 610 A1 zeigt eine Winkelmesseinrichtung bestehend aus vier Leiterplatten, welche mittels Abstandsbolzen voneinander beabstandet und übereinander angeordnet sind. Das Dokument offenbart auch, dass die Massepotentiale der vier Leiterplatten über die elektrisch leitende Abstandsbolzen so niederohmig wie möglich verbunden sind. Nachteilig an der gezeigten Leiterplattenanordnung ist jedoch, dass in keiner Weise auf die Übertragung elektrischer Signale respektive auf die Übertragung von Daten zwischen den einzelnen Leiterplatten eingegangen wird. Auch in keiner Weise wird auf die Verteilung der Versorgungsspannung auf die einzelnen Leiterplatten der Leiterplattenanordnung eingegangen.

Der Erfindung liegt die Aufgabe zugrunde, eine Leiterplattenanordnung zu schaffen, welche eine Datenübertragungsverbindung und gegebenenfalls zusätzlich eine Verteilung der Spannungsversorgung zwischen den einzelnen Leiterplatten der Leiterplattenanordnung ermöglicht, wobei die Anzahl erforderlicher Klemmen bzw. Steckverbinder auf den einzelnen Leiterplatten zur Übertragung von Daten bzw. Versorgungsspannung zwischen den einzelnen Leiterplatten reduziert wird, und gleichzeitig die Montage der Leiterplattenanordnung vereinfacht wird und die Montagekosten und Montagezeit gesenkt werden.

Die Aufgabe wird erfindungsgemäß durch die Leiterplattenanordnung mit den Merkmalen des Anspruchs 1 gelöst. Vorteilhafte Weiterbildungen sind Gegenstand der hierauf rückbezogenen Unteransprüche.

Eine erfindungsgemäße Leiterplattenanordnung besteht aus mindestens zwei Leiterplatten, welche mittels elektrisch-leitenden Abstandsbolzen voneinander beabstandet und elektrisch miteinander verbunden sind. Die Leiterplattenanordnung umfasst mindestens zwei Abstandsbolzen, einen ersten und mindestens einen zweiten Abstandsbolzen, welche zur Herstellung einer Datenübertragungsverbindung zwischen einer ersten und mindestens einer zweiten Leiterplatte vorgesehen sind.

Vorteilhafterweise reduziert eine Datenübertragung zwischen Leiterplatten mittels elektrisch-leitenden Abstandsbolzen die Anzahl der benötigten Steckverbinder respektive Klemmen. Da Abstandsbolzen ohnehin häufig zur Beabstandung und zur mechanischen Verbindung von Leiterplattenanordnungen verwendet werden, erhöht die zusätzliche Nutzung der Abstandsbolzen zur Datenübertragung in keiner Weise den Montageaufwand, sondern reduziert diesen sogar. Für die Montage von Steckverbindern respektive Klemmen auf den Leiterplatten ist meist eine manuelle Tätigkeit erforderlich. Eine manuelle Bearbeitung erhöht aber den Fertigungsaufwand, die Produktionszeit und führt auch zu höheren Ungenauigkeiten bei der Montage. Durch den Einsatz handelsüblicher Abstandsbolzen zur Datenübertragung zwischen den einzelnen Leiterplatten wird die Herstellung der Leiterplattenanordnungen vereinfacht und weniger für Fehler anfällig, da für eine Datenübertragung zwischen den einzelnen Leiterplatten keine zusätzlichen Klemmen respektive Steckverbinder montiert werden müssen. Auch wird durch den Wegfall der Klemmen für die Datenübertragung mehr Platz auf der Leiterplatte verfügbar bzw. die Leiterplatten-Größe kann reduziert werden.

Darüber hinaus weisen die Leiterplatten zur Herstellung einer elektrischen Verbindung zwischen Leiterplatte und Abstandsbolzen bevorzugt Kontaktflächen auf, wobei die Kontaktflächen bevorzugt vergoldet sind, um eine optimale elektrische Verbindung zwischen einer Kontaktfläche und einem ersten bzw. zweiten Ende eines Abstandsbolzen zu erreichen. Die Kontaktflächen können eine Bohrung aufweisen, welche es erlaubt, das an einem ersten oder zweiten Ende eines Abstandsbolzens befindliche Außengewinde durch die Bohrung zu führen und entsprechend mit einem Gegenstück zum Außengewinde, welches auf das Außengewinde aufgeschraubt wird, die Leiterplatte und den Abstandsbolzen miteinander zu fixieren. Es ist auch denkbar, Kontaktflächen ohne Bohrungen vorzusehen, wobei die Abstandsbolzen beispielsweise auf die Kontaktfläche aufgelötet oder eingepresst werden. Die Kontaktflächen können sowohl an der Unterseite als auch an der Oberseite der Leiterplatte aufgebracht sein oder auch nur an einer der beiden Seiten.

Vorteilhafterweise sind die Kontaktflächen bevorzugt sowohl auf der Oberseite als auch an der Unterseite der Leiterplatte ausgebildet, um die Leiterplatte für verschiedene Positionen innerhalb der Leiterplattenanordnung universell einsetzen zu können.

Durch die Kontaktflächen sowohl an der Oberseite als auch der Unterseite der Leiterplatte sind die einzelnen Leiterplatten flexibel in einer beliebigen Ebene der Leiterplattenanordnung positionierbar, sowohl innerhalb der Leiterplattenanordnung, als auch in der obersten und untersten Ebene der Leiterplattenanordnung.

Bevorzugt besteht die erfindungsbemäße Leiterplattenanordnung aus Leiterplatten, deren Kontaktflächen so angeordnet sind, dass die Kontaktflächen der ersten Leiterplatte und der zumindest zweiten Leiterplatte nur in einer Position der Leiterplatten zueinander deckungsgleich sind. Vorteilhafterweise verhindert die Deckungsgleichheit der Kontaktflächenanordnung der ersten Leiterplatte und der zumindest zweiten Leiterplatte in nur einer Position der Leiterplatten zueinander eine falsche Montage der Leiterplattenanordnung, da bei falscher Positionierung der Leiterplatten zueinander nicht alle Kontaktflächen der ersten Leiterplatte genau unterhalb der Kontaktflächen der zweiten Leiterplatte befindlich sind.

In einer weiteren vorteilhaften vorzugsweisen Ausgestaltung ist zu jeder Kontaktfläche auf der Leiterplatte in einem horizontalen Abstand d eine zusätzliche Kontaktfläche ausgebildet. Der horizontale Abstand d ist für alle zusätzlichen Kontaktflächen identisch und jede Kontaktfläche ist mit ihrer horizontal beabstandeten zusätzlichen Kontaktfläche elektrisch leitend verbunden.

Weiterhin vorteilhafterweise sind die Leiterplatten vorzugsweise terrassenförmig versetzt zueinander angeordnet, indem der erste und der zumindest zweite Abstandsbolzen an ihrem ersten Ende ausschließlich mit den zusätzlichen Kontaktflächen der ersten Leiterplatte elektrisch verbunden sind, und indem der erste und der zumindest zweite Abstandsbolzen an ihrem zweiten Ende ausschließlich mit den Kontaktflächen der zweiten Leiterplatte elektrisch verbunden sind. Vorteilhafterweise kann diese terrassenartige Versetzung der Leiterplatten zueinander analog für eine dritte, vierte oder auch mehr Leiterplatten fortgesetzt werden.

Vorteilhafterweise erlaubt die bevorzugte Erweiterung der einzelnen Leiterplatten der Leiterplattenanordnung mit um einen horizontalen Abstand beabstandeten zusätzlichen Kontaktflächen ein Verschieben der jeweils darüber liegenden Leiterplatte um diesen Abstand. Somit kommt es zu einer terrassenförmigen Verschiebung der Leiterplatten zueinander. Dies ist besonders vorteilhaft, wenn Klemmen auf den Leiterplatten vorhanden sind, welche von oben zugänglich sein sollen, um beispielsweise eine Klemmschraube zu lösen oder anzuziehen. Bei bündig übereinander liegenden Leiterplatten ist es erforderlich, die Leiterplatten abzumontieren, um zur gewünschten Klemme Zugang zu erhalten. Eine terrassenförmige Anordnung erlaubt einen Zugang zu den Klemmen in jeder Ebene der Leiterplattenanordnung.

Vorteilhafterweise, kann der horizontale Abstand in Abhängigkeit der gewünschten Verschiebung der einzelnen Leiterplatten zueinander gewählt werden. Beispielsweise in Abhängigkeit der Breite und/oder der Positionierung der verwendeten Klemmen, Klemmblöcke bzw. anderer Verbindungsvorrichtungen.

Weiterhin vorteilhafterweise können mittels dem ersten und zweiten Abstandsbolzen gleichzeitig die Spannungsversorgung geführt und die Datenübertragungsverbindung hergestellt werden.

Gemäß einer weiteren vorteilhaften bevorzugten Ausgestaltung der Leiterplattenanordnung werden mittels des ersten und des mindestens zweiten Abstandsbolzens die Signale CAN H und CAN L einer CAN-Bus Verbindung oder einer anderen seriellen Datenübertragungsverbindung zwischen der ersten und zweiten Leiterplatte übertragen.

Zusätzlich oder alternativ sind weitere Abstandsbolzen zur Signalübertragung anderer paralleler Datenübertragungsverbindungen vorhanden. Vorteilhafterweise können durch Hinzufügen von weiteren Abstandsbolzen zusätzliche Datenübertragungsverbindungen geschaffen werden, ohne zusätzliche Klemmen respektive Steckverbinder montieren zu müssen.

Bevorzugt, werden mittels der Abstandsbolzen Feldbussignale, wie CAN-Bus Signale, Profibus Signale, Interbus-S Signale und/oder AS-Interface Signale übertragen. Zusätzlich oder alternativ dazu werden serielle Signale, wie RS232 Signale, I²C Signale, SPI Signale und/oder One-Wire Signale, und/oder parallele Signale, wie GPIO Signale und/oder einzelne Bits übertragen.

Vorzugsweise wird mittels eines weiteren Abstandsbolzens oder mittels des ersten oder zweiten Abstandsbolzens die elektrische Masseverbindung zwischen der ersten und zumindest zweiten Leiterplatte geführt.

Bevorzugt wird auch die Versorgungsspannung zwischen der ersten und zumindest zweiten Leiterplatte mittels zumindest eines weiteren Abstandsbolzens geführt.

Nachfolgend werden Ausführungsbeispiele der Erfindung anhand der Zeichnung, beispielhaft beschrieben. In der Zeichnung zeigen:
- Fig. 1: ein Blockdiagramm eines Bus-Systems mit mehreren Bus-Teilnehmern;
- Fig. 2: ein Blockdiagramm eines CAN-Bus-Systems mit mehreren CAN Knoten;
- Fig. 3: ein erstes Ausführungsbeispiel der erfindungsgemäßen Leiterplattenanordnung;
- Fig. 4: eine Draufsicht des ersten Ausführungsbeispiels gemäß Fig. 3;
- Fig. 5: ein zweites Ausführungsbeispiel der erfindungsgemäßen Leiterplattenanordnung;
- Fig. 6: eine Draufsicht des zweiten Ausführungsbeispiels gemäß Fig. 5;
- Fig. 7A: eine Seitenansicht einer Leiterplatte der erfindungsgemäßen Leiterplattenanordnung mit Kontaktflächen auf der Ober- und Unterseite, ohne Bohrung;
- Fig. 7B: eine Seitenansicht einer Leiterplatte der erfindungsgemäßen Leiterplattenanordnung mit Kontaktflächen auf der Ober- und Unterseite, mit Bohrung;
- Fig. 7C: eine Seitenansicht der erfindungsgemäßen Leiterplattenanordnung zur gleichzeitigen Übertragung von Versorgungsspannung und Daten;
- Fig. 8A: eine Draufsicht einer Leiterplatte der erfindungsgemäßen Leiterplattenanordnung mit Kontaktflächen und horizontal beabstandeten, zusätzlichen Kontaktflächen;
- Fig. 8B: eine Draufsicht der erfindungsgemäßen Leiterplattenanordnung mit terrassenförmig zueinander angeordneten Leiterplatten gemäß Fig. 8A;
- Fig. 9: eine Seitenansicht terrassenförmig zueinander angeordneter Leiterplatten gemäß Fig. 8B;
- Fig. 10: ein Teilschnitt eines Abstandsbolzens mit Innen- und Außengewinde, und
- Fig. 11: ein Teilschnitt eines Abstandsbolzens mit Innen- und Innengewinde.

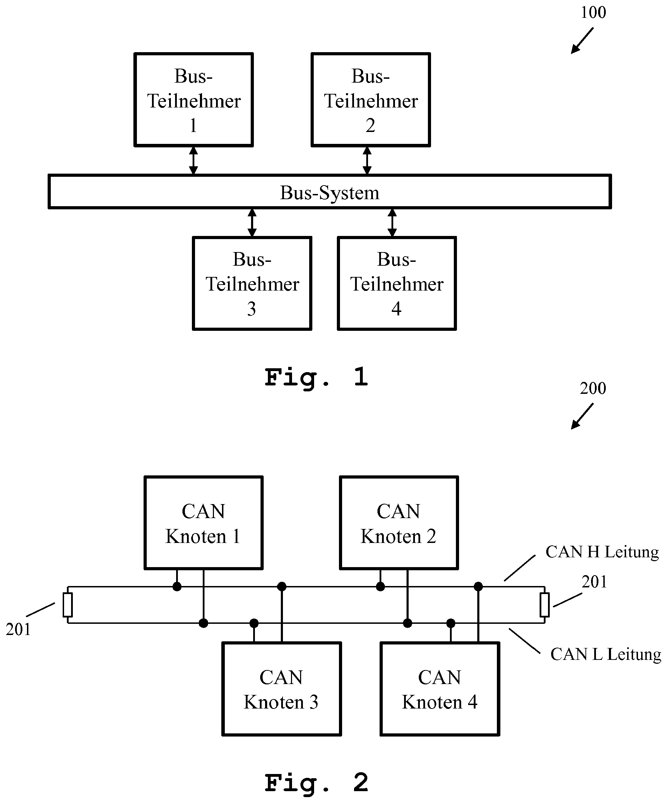

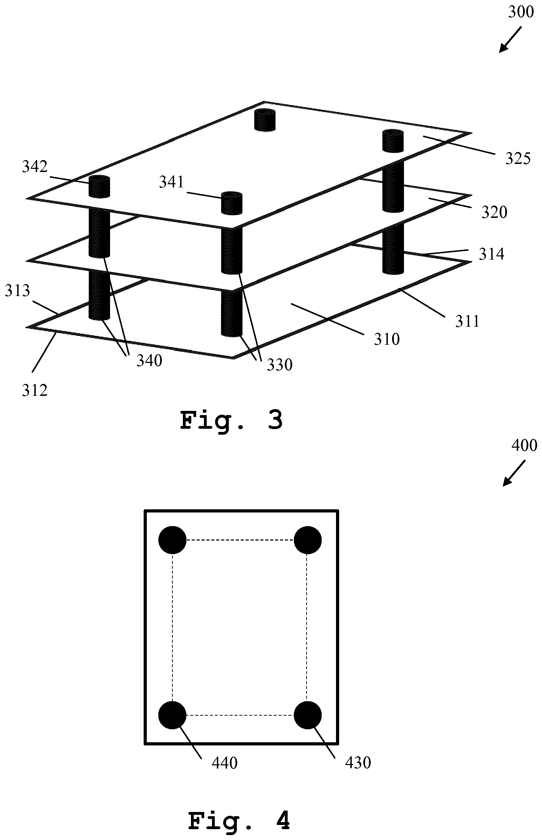

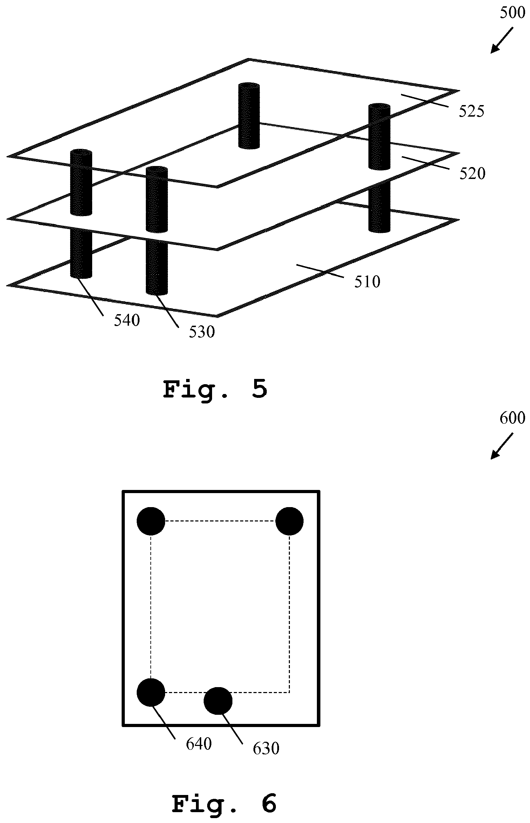

Die Bezugszeichen in Fig. 1 - 11 sind alle dreistellig gewählt und beginnen jeweils mit der, der Figurennummer entsprechenden Zahl. Die Zehner- und Einer Stellen der Referenznummern sind für identische Elemente in verschiedenen Figuren gleich gewählt. Beispielsweise werden die Abstandsbolzen in Fig. 3 mit den Bezugszeichen 330, 340 benannt, während die Abstandsbolzen in Fig. 5 mit den Bezugszeichen 530, 540 bezeichnet werden. Die Vorgehensweise wird analog für alle Figuren angewandt. Gleiche Elemente werden in einer Abbildung meist nur einmal beschriftet, um die Lesbarkeit der Abbildungen nicht zu beeinträchtigen.

In Fig. 1 ist ein Blockdiagramm eines Bus-Systems 100 gezeigt, welches der Datenübertragung zwischen mehreren Teilnehmern über einen gemeinsamen Übertragungsweg dient. Die Datenübertragung kann seriell erfolgen, wobei digitale Daten autonom jeweils auf einer Leitung (bzw. auf einem Leitungspaar) übertragen werden. Bei parallelen Datenübertragungen werden Daten synchron oder asynchron über mehrere Leitungen übertragen.

Bus-Systeme finden Anwendung insbesondere innerhalb von Computern und zur Verbindung von Computern mit Peripheriegeräten. Des Weiteren werden Bus-Systeme auch zur Ansteuerung von Maschinen (Feldbusse) verwendet, und üblicherweise auch in der Automobiltechnik zur Verbindung einzelner elektronischer Systemkomponenten eines Fahrzeugs eingesetzt. Aber auch in der Gebäudetechnik zur Steuerung von Beleuchtung, Fenster, Türen, Heizung, Klimaanlagen, etc. gewinnen Bus-Systeme immer mehr an Bedeutung.

Fig. 2 zeigt ein Blockdiagramm 200 einer möglichen Variante eines seriellen Bus-Systems, nämlich den CAN Bus. Der CAN-Bus verbindet mehrere gleichberechtigte Steuergeräte respektive Einheiten, in Fig. 2 mit CAN Knoten 1 bis CAN Knoten 4 bezeichnet, über einen 2-Draht Bus miteinander. Wie in Fig. 2 gezeigt, wird eine Bus-Leitung mit CAN H und die andere Bus-Leitung mit CAN L bezeichnet. Der CAN Bus wird an seinen beiden Enden üblicherweise mit je einem 120 Ohm Widerstand 201 terminiert, um Reflexionen auf den Leitungen zu vermeiden.

Der CAN Bus weist vorteilhafterweise eine hohe elektrische Störsicherheit auf, indem ein Bit auf zwei Leitungen gleichzeitig mit einer gegensinnigen Potentialänderung abgebildet wird, dies wird auch als differentielles Signal bezeichnet. Somit heben sich eingestreute Gleichtakt-Störungen, die auf beide Leitungen wirken, aufgrund des differentiellen Signals auf und der zu übertragende Pegel bleibt auch bei Störungen weitgehend erhalten. Aufgrund der hohen Störunempfindlichkeit wird der CAN Bus im Rahmen dieser Erfindung bevorzugt eingesetzt, beispielsweise für die Kommunikation einer Steuereinheit mit beispielsweise einer Treiberstufe für eine LASER Einheit. Auch die Datenübertragung innerhalb einer solchen Treiberstufe zwischen einzelnen Baugruppen respektive zwischen einzelnen Leiterplatten erfolgt erfindungsgemäß bevorzugt mittels einer CAN Bus Verbindung.

Fig. 3 zeigt ein erstes Ausführungsbeispiel der erfindungsgemäßen Leiterplattenanordnung 300, die beispielsweise in einer Treiberstufe für eine LASER Einheit eingesetzt werden kann. Die minimale Konfiguration der erfindungsgemäßen Leiterplattenanordnung besteht aus zwei parallelen Leiterplatten und zwei Abstandsbolzen.

Zur besseren Beschreibung des Aufbaus der erfindungsgemäßen Leiterplattenanordnung, wird, wie in Fig. 3 eine Darstellung von drei parallelen Leiterplatten und vier Abstandsbolzen gewählt.

Die gezeigte Leiterplattenanordnung 300 besteht aus drei Leiterplatten 310, 320, 325, die an all ihren vier Seiten 311, 312, 313, 314 in diesem Ausführungsbeispiel bündig übereinander angeordnet sind. Die zweite Leiterplatte 320 ist durch einen ersten Abstandsbolzen 330, einen zweiten Abstandsbolzen 340 und zwei weiteren Abstandsbolzen von der ersten Leiterplatte 310 beabstandet und mit dieser elektrisch verbunden. Analog dazu ist die dritte Leiterplatte 325 durch einen ersten Abstandsbolzen 330, einen zweiten Abstandsbolzen 340 und zwei weiteren Abstandsbolzen von der zweiten Leiterplatte 320 beabstandet und mit dieser elektrisch verbunden.

Jeweils das erste Ende der beispielhaft vier in Fig. 3 gezeigten Abstandsbolzen liegt auf der Oberseite der ersten Leiterplatte 310 auf und ist mit dieser mittels Lötverbindung, Einpressverbindung oder auch mittels einer Schraubverbindung mechanisch und elektrisch verbunden.

Das jeweils zweite Ende der beispielhaft vier Abstandsbolzen ist mit der Unterseite der zweiten Leiterplatte 320 mittels Lötverbindung, Einpressverbindung oder auch mittels einer Schraubverbindung mechanisch und elektrisch verbunden.

Analog zur beschriebenen Verbindung zwischen der ersten Leiterplatte 310 und der zweiten Leiterplatte 320 wird auch die Verbindung der zweiten Leiterplatte 320 und der dritten Leiterplatte 325 durchgeführt und kann für weitere Leiterplatten fortgesetzt werden.

Fig. 3 zeigt beispielhaft einen Abschluss der Leiterplattenanordnung 300 mittels Muttern 341, 342 oder geeigneten Schrauben 341, 342, die die oberste Leiterplatte der Anordnung mit den zweiten Enden der Abstandsbolzen fixieren.

Bei diesem Ausführungsbeispiel werden zwei Abstandsbolzen für die Stromversorgung verwendet. Beispielsweise werden über die ersten Abstandsbolzen 330 die negative Versorgungsspannung VSS bzw. die Masse geführt und über die zweiten Abstandsbolzen 340 die positive Versorgungsspannung VDD geführt. Die beiden anderen Abstandsbolzen dienen zur Datenübertragung beispielsweise eines differenziellen Datenübertragungs-Signals, beispielsweise der Signale CAN H und CAN L. Diese Ausgestaltung hat den Vorteil, dass die beiden Abstandsbolzen, welche der Datenübertragung dienen, von den Abstandsbolzen 340 und 330, welche zur Führung der Versorgungsspannung bzw. zur Masseführung dienen, galvanisch getrennt sind. Denkbar ist es auch, nur drei Abstandsbolzen zur Datenübertragung und zur Zuführung der Versorgungsspannung zu verwenden, wenn die Versorgungsspannung und die Datenübertragung auf ein gemeinsames Massepotential zugreift, welches über einen der Abstandsbolzen geführt wird. Dann kann es sogar ausreichen, insgesamt nur drei Abstandsbolzen zu verwenden. Die Verwendung von vier Abstandsbolzen hat jedoch bezüglich der mechanischen Stabilität Vorteile.

Häufig werden zur Realisierung von Treiberstufen, insbesondere für Treiberstufen für LASER-STACKs, mehrere identische bzw. sehr ähnlich aufgebaute Leiterplatten übereinander angeordnet, um platzsparend in einem Gehäuse untergebracht werden zu können. Insbesondere ist für solche Treiberstufen eine Anordnung gemäß Fig. 3 vorteilhaft, da ohnehin Abstandsbolzen verwendet werden, um die Beabstandung der Leiterplattenanordnung zu realisieren und die einzelnen Leiterplatten miteinander mechanisch zu verbinden. Eine Verwendung der Abstandsbolzen zur Herstellung zumindest einer Datenverbindung zwischen den voneinander beabstandeten Leiterplatten ist vorteilhaft, da die Montage vereinfacht wird, weniger Klemmblöcke, Klemmleisten, Stiftleisten respektive Steckverbinder benötigt werden und der manuelle Fertigungsaufwand reduziert wird.

Fig. 4 zeigt eine Draufsicht 400 der Leiterplattenanordnung 300 gemäß Fig. 3. Die Fig. 4 soll verdeutlichen, dass bei einer Anordnung der vier Abstandsbolzen auf den Eckpunkten eines Rechtecks in jeder Leiterplattenebene alle vier Abstandsbolzen aller Leiterplattenebenen nur für zwei Positionen der Leiterplatten zueinander deckungsgleich sind. Die in Fig. 4 gezeigte Deckungsgleichheit der vier Abstandsbolzen ist in der Ausgangsposition gegeben, auch wenn eine oder mehrere Leiterplatten 310, 320, 325 der Leiterplattenanordnung um 180° bzw. ggf. auch 90° und 270° für den Fall eines Quadrats in der Horizontalebene, also in der Ebene parallel zur Leiterplattenebene befindlich, zueinander verdreht werden.

Fig. 5 zeigt eine erfindungsgemäße Leiterplattenanordnung 500, welche der Leiterplattenanordnung aus Fig. 3 sehr ähnlich ist. Allerdings, ist die Position des ersten Abstandsbolzens 530 unterschiedlich zur Position des ersten Abstandsbolzens 330, der in Fig. 3 dargestellt ist und liegt nicht auf dem Eckpunkt eines Rechtecks. Eine solche Anordnung der Abstandsbolzen reduziert die Fehlermöglichkeiten bei der Montage der Leiterplattenanordnung, da ein Zusammenbau nur in einer Positionen der Leiterplatten zueinander möglich ist.

Fig. 6 zeigt eine Draufsicht der Leiterplattenanordnung 500 gemäß Fig. 5. Die Fig. 6 soll verdeutlichen, dass die Anordnung der vier Abstandsbolzen dergestalt gewählt ist, dass zumindest einer der Abstandsbolzen, beispielhafterweise der erste Abstandsbolzen 530, 630, nicht wie die übrigen drei Abstandsbolzen auf den Eckpunkten eines Rechtecks liegt.

Eine identische Anordnung der Abstandsbolzen in allen Leiterplattenebenen führt nur in der in Fig. 5 bzw. Fig. 6 gezeigten Position der einzelnen Leiterplatten 510, 520, 525 zueinander zu einer Deckungsgleichheit aller Abstandsbolzen einer Leiterplattenebene mit allen Abstandsbolzen der anderen Leiterplattenebenen. Im Gegensatz zur Darstellung in Fig. 3 und Fig. 4 erlaubt die Position der Abstandsbolzen gemäß Fig. 5 und 6 keinerlei Verdrehen der einzelnen Leiterplatten zueinander, da dann keine Deckungsgleichheit aller Abstandsbolzen der verschiedenen Leiterplattenebenen gegeben ist.

Verschiedenste Anordnungen der Abstandsbolzen sind denkbar, so dass eine Montage der Leiterplattenanordnung nur in einer Position der Leiterplatten zueinander möglich ist. Dies verhindert vorteilhafterweise einen unsachgemäßen Zusammenbau, da keine falsche Montage aufgrund der vorgegebenen Anordnung der Abstandsbolzen möglich ist. Auch wäre eine falsche Montage sofort erkennbar, da sich zumindest ein Abstandsbolzen oder auch mehrere Abstandsbolzen nicht vollständig montieren lassen.

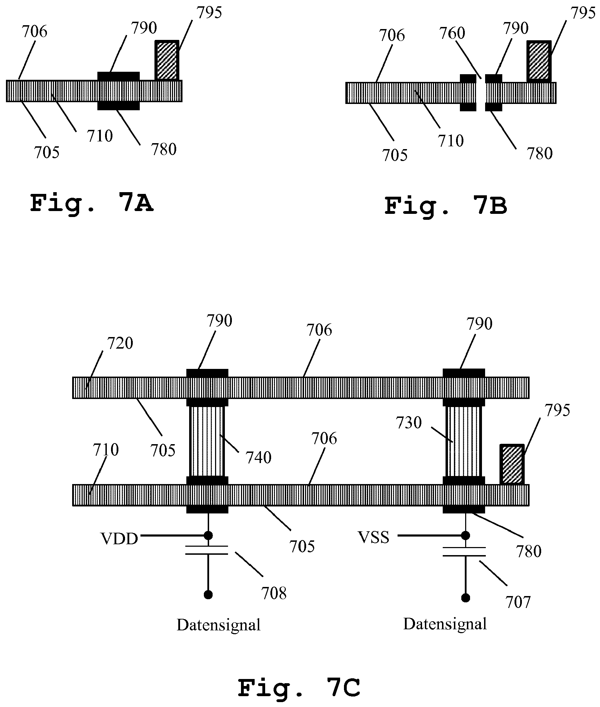

In Fig. 7A ist eine Seitenansicht eines Leiterplattenabschnitts der ersten Leiterplatte 710 der erfindungsgemäßen Leiterplattenanordnung dargestellt. Fig. 7A zeigt eine Klemme 795, respektive einen Klemmblock, respektive eine Möglichkeit zur Fixierung einzelner oder mehrerer Leitungen. Des Weiteren zeigt Fig. 7A, eine Kontaktfläche 790 auf der Oberseite 706 des Leiterplattenabschnitts, sowie eine Kontaktfläche 780 auf der Unterseite 705 des Leiterplattenabschnitts. Die Kontaktfläche auf der Oberseite 790 sowie die Kontaktfläche auf der Unterseite 780 des Leiterplattenabschnitts der Leiterplatte 710 sind elektrisch miteinander verbunden.

Fig. 7B zeigt ebenfalls eine Seitenansicht eines Leiterplattenabschnitts der ersten Leiterplatte 710 der erfindungsgemäßen Leiterplattenanordnung, allerdings wird zusätzlich zu den Kontaktflächen 780, 790, welche in Fig. 7A beschrieben sind eine Bohrung 760 gezeigt. Diese Bohrung 760 verläuft sowohl durch die Kontaktflächen 780, 790 als auch durch das Leiterplattenmaterial, auf dem die Kontaktflächen 780, 790 aufgebracht sind. Auch gemäß der Ausführungsform nach Fig. 7B sind die Kontaktflächen der Oberseite 790 sowie die Kontaktflächen der Unterseite 780 des Leiterplattenabschnitts der Leiterplatte 710 elektrisch miteinander verbunden.

Die Ausführungsform der Kontaktflächen 780, 790 mit und ohne Bohrung erlaubt die elektrische und mechanische Verbindung eines ersten Endes eines Abstandsbolzens mit Kontaktflächen 790, die sich auf der Oberseite 706 der Leiterplatten 710, 720, 725 befinden, und die elektrische und mechanische Verbindung eines zweiten Endes eines Abstandsbolzens mit den Kontaktflächen 780, die sich auf der Unterseite 705 der Leiterplatten 710, 720, 725 befinden.

Bei der Realisierung der Kontaktflächen ohne Bohrung erfolgt die Verbindung zwischen einem handelsüblichen Abstandsbolzen und den Kontaktflächen vorzugsweise mittels Lötverbindung oder Einpressverbindung, wobei auch andere Verfahren gemäß dem Stand der Technik zur Verbindung von Kontaktflächen mit Abstandsbolzen anwendbar sind.

Bei der Realisierung der Kontaktflächen mit Bohrung (760) erfolgt die Verbindung zwischen Abstandsbolzen und Kontaktflächen, indem das Außengewinde eines handelsüblichen Abstandbolzens durch die Bohrung durchgesteckt wird und auf das Außengewinde eine Mutter oder ein weiterer Abstandsbolzen mit Innengewinde aufgeschraubt wird.

Jede beliebige Kombination von Abstandsbolzen beispielsweise Abstandsbolzen mit beidseitigem Innengewinde, beidseitigem Außengewinde und je einem Außengewinde und einem Innengewinde ist denkbar, um die Leiterplattenanordnung zu realisieren.

In Fig. 7C ist eine Seitenansicht von zwei Leiterplatten 710, 720, die mittels eines ersten Abstandsbolzens 730 und eines zweiten Abstandbolzens 740 beabstandet sind gezeigt. Gemäß Fig. 7C weist jede der beiden Leiterplatten 710, 720 je zwei Kontaktflächen 790 an ihrer jeweiligen Oberseite 706 und je zwei Kontaktflächen 780 an ihrer jeweiligen Unterseite 705 auf. Das jeweils erste Ende des ersten Abstandsbolzens 730 und des zweiten Abstandsbolzens 740 ist jeweils mit der Kontaktfläche 790 der ersten Leiterplatte 710 mechanisch und elektrisch verbunden. Das jeweils zweite Ende des ersten Abstandsbolzens 730 und zweiten Abstandsbolzens 740 ist jeweils mit der Kontaktfläche 780 der zweiten Leiterplatte 720 mechanisch und elektrisch verbunden. Über die Kontaktflächen 780 der Unterseite 706 der ersten Leiterplatte 710 wird einerseits der erste Abstandsbolzen 730 elektrisch mit der negativen Versorgungsspannung VSS bzw. mit Masse verbunden und gleichzeitig mit dem Datensignal, welches über den Kondensator 707 eingekoppelt wird. Andererseits wird der zweite Abstandsbolzen 740 mit der positiven Versorgungsspannung VDD verbunden und gleichzeitig mit dem Datensignal, welches über den Kondensator 708 eingekoppelt wird.

Es ist auch denkbar, dass andere Verfahren der gleichzeitigen Übertragung von Versorgungsspannung und elektrischen Signalen respektive Daten zur Anwendung kommen.

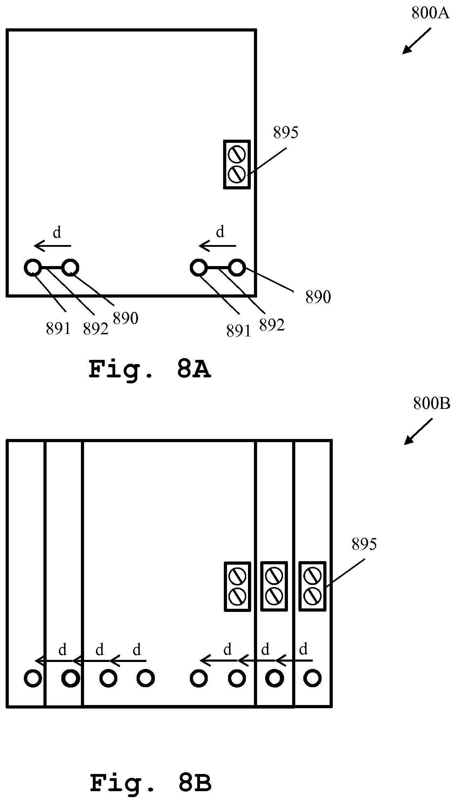

Fig. 8A zeigt eine Draufsicht 800A einer einzelnen Leiterplatte der erfindungsgemäßen Leiterplattenanordnung. Die dargestellte Leiterplatte weist eine 2-polige Schraubklemme 895 auf. Des Weiteren zeigt Fig. 8A Kontaktflächen 890 auf der Oberseite der Leiterplatte, welche bereits in den Figuren 7A und 7B mit der Referenznummer 790 beschrieben sind. Auf der Unterseite der einzelnen Leiterplatte, welche in der Draufsicht 800A dargestellt ist, befinden sich die Kontaktflächen 880, welche in den Figuren 7A und 7B bereits mit der Referenznummer 780 gezeigt sind.

Zusätzlich zu den bisher beschriebenen Kontaktflächen 880, 890 sind zusätzliche Kontaktflächen 881, 891 ausgebildet, welche jeweils mit einem horizontalen Abstand d von den jeweiligen Kontaktflächen 880, 890 beabstandet sind und jeweils elektrisch 882, 892 miteinander verbunden sind.

Alle Leiterplatten der Leiterplattenanordnung weisen eine identische Anordnung der Kontaktflächen auf, so dass ein bündiges Übereinanderlegen aller Leiterplatten zu einer Deckungsgleichheit aller Kontaktflächen 890, 891 der Leiterplattenoberseite, sowie zu einer Deckungsgleichheit aller Kontaktflächen 880, 881 der Leiterplattenunterseite führt.

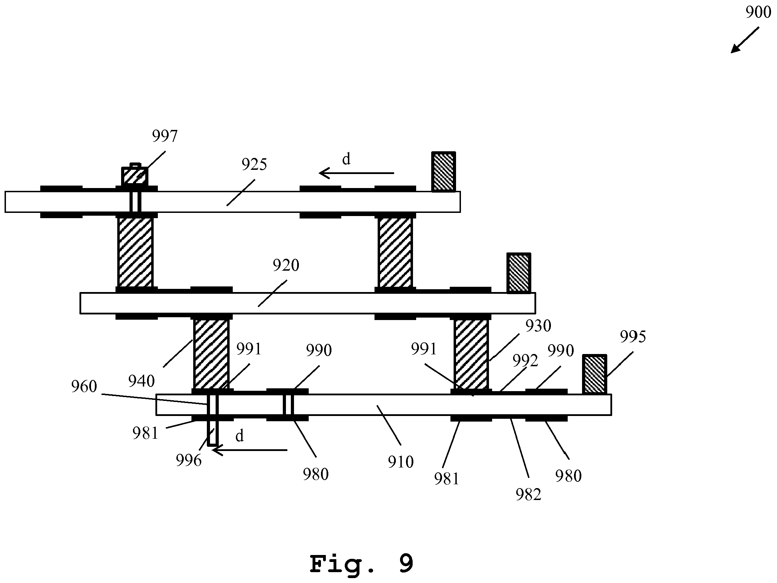

In Fig. 8B ist eine Draufsicht von drei terrassenförmig zueinander angeordneten Leiterplatten gezeigt, welche jeweils Kontaktflächen 880, 890 und zusätzliche Kontaktflächen 881, 891 aufweisen, wobei die jeweiligen Kontaktflächen mit den jeweiligen zusätzlichen Kontaktflächen elektrisch, beispielsweise mittels einer Leiterbahn 882, 892, miteinander verbunden sind. Da aufgrund der Draufsicht eine Beschriftung mit Referenzeichen nicht möglich ist, wird der Bezug mit den Referenznummern der Fig. 9 hergestellt. Die Kontaktflächen 880, 890 und 881, 891 aus Fig. 8B sind identisch zu den Kontaktflächen 980, 990 und 981, 991. Die Leiterbahnen 882, 892 aus Fig. 8B sind identisch zu den Kontaktflächen 982, 992 aus Fig. 9.

Fig. 8B soll mittels der Draufsicht 800B zunächst zeigen, dass die Schraubklemmen 895 aufgrund der terrassenförmigen Anordnung der einzelnen Leiterplatten zueinander, ebenfalls terrassenartig zueinander versetzt sind und somit die Schrauben der Schraubklemmen leicht zugänglich sind, ohne Leiterplatten aus der Leiterplattenanordnung entfernen zu müssen.

Fig. 9 zeigt eine Seitenansicht der in Fig. 8B dargestellten Draufsicht der Leiterplattenanordnung 800B, welche aus zueinander terrassenförmigen Leiterplatten 910, 920, 925 aufgebaut ist. Fig. 9 zeigt, dass jede Leiterplatte 910, 920, 925 Kontaktflächen 990 an ihrer Oberseite aufweist, und dass zu jeder der Kontaktflächen 990 eine zusätzliche Kontaktfläche 991 vorhanden ist, die mit einem Abstand d horizontal von der jeweiligen Kontaktfläche 990 beabstandet ist, wobei die jeweiligen Kontaktflächen 990 und die jeweiligen zusätzlichen Kontaktflächen 991 mittels einer Leiterbahn 992 elektrisch miteinander verbunden sind.

Des Weiteren zeigt Fig. 9, dass jede Leiterplatte 910, 920, 925 Kontaktflächen 980 an ihrer Unterseite aufweist, und dass zu jeder der Kontaktflächen 980 eine zusätzliche Kontaktfläche 981 vorhanden ist, die mit einem Abstand d horizontal von der jeweiligen Kontaktfläche 980 beabstandet ist, wobei die jeweiligen Kontaktflächen 980 und die jeweiligen zusätzlichen Kontaktflächen 981 mittels einer Leiterbahn 982 elektrisch miteinander verbunden sind.

Dadurch, dass jede Leiterplatte 910, 920, 925 zu jeder Kontaktfläche 980, 990 eine zusätzliche Kontaktfläche 981, 991 aufweist, wobei die jeweilige Kontaktfläche der Oberseite 990 mit der jeweiligen zusätzlichen Kontaktfläche 991 der Leiterplattenoberseite elektrisch, beispielsweise mittels einer Leiterbahn 992, verbunden ist und die jeweilige Kontaktfläche 980 der Leiterplattenunterseite mit der jeweiligen zusätzlichen Kontaktfläche 981 der Leiterplattenunterseite elektrisch, beispielsweise mittels einer Leiterbahn 982, verbunden ist, können die einzelnen Leiterplatten 910, 920, 925 ohne zusätzlichen Aufwand terrassenförmig zueinander verschoben und montiert werden, ohne elektrische Verschaltungen zu beeinflussen.

Aufgrund der gezeigten Ausführung mit zusätzlichen Kontaktflächen 981, 991, ist sowohl eine bündige als auch eine terrassenförmige Montage der einzelnen Leiterplatten zueinander möglich, ohne das Leiterplattenlayout ändern zu müssen.

Oftmals sind Klemmen auf den Leiterplatten verbaut, welche bei einer bündigen Montage der einzelnen Leiterplatten zueinander nicht zugänglich sind und somit die Montage erschweren bzw. den manuellen Arbeitsaufwand erhöhen. In einem solchen Fall ist die terrassenförmige Anordnung der Leiterplatten zueinander zu bevorzugen und ohne Aufwand möglich.

In der Darstellung in Fig. 9 sind Kontaktflächen sowohl mit Bohrung, als auch ohne Bohrung dargestellt. Fig. 9 zeigt, wie der zweite Abstandsbolzen 940, der an seinem ersten Ende ein Außengewinde 996 aufweist, durch die Bohrung 960 geführt ist. Mittels einer Schrauben-Mutter oder einem geeigneten Abstandsbolzen, der an seinem zweiten Ende ein Innengewinde aufweist und auf das Außengewinde 996 geschraubt wird, wird der zweite Abstandsbolzen 940 mit der ersten Leiterplatte 910 fixiert. Die Verschraubung mit dem Außengewinde ist dabei nicht gezeigt.

Auch zeigt Fig. 9 einen zweiten Abstandsbolzen 940, der zwischen der zweiten 920 und dritten 925 Leiterplatte angeordnet ist und der an seinem zweiten Ende ein Außengewinde aufweist. Das genannte Außengewinde ist durch eine Bohrung in der dritten Leiterplatte 925 geführt. Mittels einer Schrauben-Mutter 997, die auf das Außengewinde geschraubt wird, wird der zweite Abstandsbolzen mit seinem zweiten Ende mit der dritten Leiterplatte 925 fixiert.

Die erfindungsgemäße Leiterplattenanordnung kann ausschließlich Kontaktflächen ohne Bohrung oder Kontaktflächen mit Bohrung aufweisen. Ebenso ist eine Kombination aus Kontaktflächen mit oder ohne Bohrung denkbar.

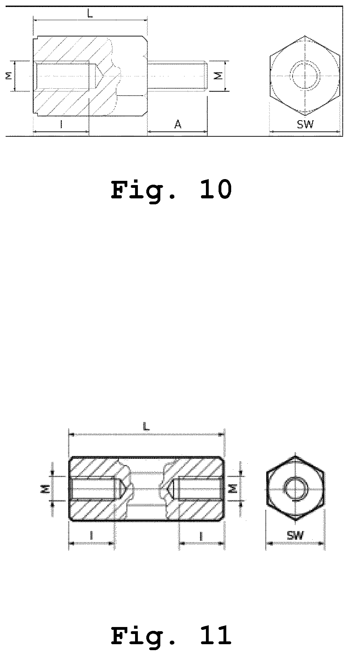

Abschließend zeigen Fig. 10 und Fig. 11 zwei im Rahmen der Erfindung verwendbare Abstandsbolzen, wobei Fig. 10 einen Abstandsbolzen mit einem Außengewinde an seinem ersten Ende befindlich und einem Innengewinde an seinem zweiten Ende befindlich zeigt. Fig. 11 zeigt einen Abstandsbolzen mit Innengewinde an seinen beiden Enden befindlich.

Eine sehr große Anzahl an elektrisch-leitfähigen Abstandsbolzen ist standardmäßig verfügbar, wobei verschiedenste Längen und Größen, wie beispielsweise M2, M4, M8, etc. erhältlich sind. Auch Abstandsbolzen mit Außen/Außengewinde sind verfügbar, wobei alle Varianten der Abstandsbolzen standardmäßig in verschiedenen Materialien erhältlich sind, wie beispielsweise Stahl oder Messing. Die Abstandsbolzen der erfindungsgemäßen Leiterplattenanordnung sind bevorzugt aus Messing gefertigt. Ein Abstandsbolzen mit Außengewinde der durch eine Bohrung einer Kontaktfläche gesteckt wird, kann in das geeignete Innengewinde eines weiteren Abstandsbolzens geschraubt werden, um eine Verbindung zwischen beiden Bolzen herzustellen und gleichzeitig die Leiterplatte zwischen den beiden Abstandsbolzen zu fixieren. Des Weiteren kann auch eine Mutter auf das durch eine Bohrung einer Kontaktfläche geführte Außengewinde eines Abstandbolzens geschraubt werden, um die Leiterplatte zwischen dem Abstandsbolzen und der Schrauben-Mutter zu fixieren.

Zur Fixierung einer beispielsweise ersten Leiterplatte an einem Gehäuse, Kühlkörper oder Untergrund sind ebenfalls Abstandsbolzen denkbar, welche lediglich eine mechanische Funktion erfüllen und keine Versorgungsspannung führen und auch keine Datenverbindung herstellen. Derartige Abstandsbolzen können auch aus einem nicht leitenden Material bestehen.

Es ist ebenfalls denkbar, dass mittels einem oder mehrerer elektrisch-leitenden Abstandsbolzen eine Masseverbindung zwischen den Leiterplatten und dem Gehäuse oder dem Kühlkörper hergestellt wird.

Die Erfindung ist nicht auf das dargestellte Ausführungsbeispiel beschränkt. Die Leiterplattenanordnung kann auch aus einer Kombination von terrassenförmig zueinander versetzten und bündig übereinander liegenden Leiterplatten bestehen. Mithilfe der Abstandsbolzen können verschiedenste Busverbindungen zwischen den einzelnen Leiterplatten innerhalb der Leiterplattenanordnung realisiert werden. Alle vorstehend beschriebenen Merkmale oder in den Figuren gezeigten Merkmale oder in den Ansprüchen beanspruchten Merkmale sind im Rahmen der Erfindung beliebig vorteilhaft miteinander kombinierbar.

## Patentansprüche

1. Leiterplattenanordnung (300) bestehend aus mindestens zwei Leiterplatten (310, 320), welche mittels elektrisch-leitenden Abstandsbolzen (330, 340) voneinander beabstandet und elektrisch miteinander verbunden sind, **dadurch gekennzeichnet,**
**dass** ein erster Abstandsbolzen (330) und mindestens ein zweiter (340) Abstandsbolzen zur Herstellung einer Datenübertragungsverbindung zwischen einer ersten Leiterplatte (310) und mindestens einer zweiten Leiterplatte (320) vorgesehen sind.

2. Leiterplattenanordnung nach Anspruch 1,
**dadurch gekennzeichnet,**
**dass** die Leiterplatten (310, 320) zur Herstellung einer elektrischen Verbindung zwischen Leiterplatte (310) und Abstandsbolzen (330, 340) Kontaktflächen (780, 790) mit oder ohne Bohrung (760) an ihrer Unter (705)- und/oder Oberseite (706) aufweisen.

3. Leiterplattenanordnung nach Anspruch 2,
**dadurch gekennzeichnet,**
**dass** die Kontaktflächen (780, 790) der Leiterplatten (510, 520) so angeordnet sind, dass die Kontaktflächen (780, 790) der ersten Leiterplatte (510) und der zumindest zweiten Leiterplatte (520) nur in einer Position der Leiterplatten (500) zueinander deckungsgleich sind.

4. Leiterplattenanordnung nach Anspruch 2 oder 3,
**dadurch gekennzeichnet,**
**dass** zu jeder Kontaktfläche (890) auf der Leiterplatte in einem horizontalen Abstand (d) eine zusätzliche Kontaktfläche (891) ausgebildet ist, wobei der horizontale Abstand (d) für alle zusätzlichen Kontaktflächen identisch ist und jede Kontaktfläche (890) mit ihrer horizontal beabstandeten zusätzlichen Kontaktfläche (891) elektrisch leitend verbunden ist.

5. Leiterplattenanordnung nach einem der Ansprüche 2 bis 4,
**dadurch gekennzeichnet,**
**dass** die Leiterplatten (910, 920) terrassenförmig versetzt zueinander angeordnet sind, indem der erste Abstandsbolzen (930) und der zumindest zweite Abstandsbolzen (940) an ihrem ersten Ende ausschließlich mit den zusätzlichen Kontaktflächen (991) der ersten Leiterplatte (910) elektrisch verbunden sind, und indem der erste Abstandsbolzen (930) und der zumindest zweite Abstandsbolzen (940) an ihrem zweiten Ende ausschließlich mit den Kontaktflächen (981) der zweiten Leiterplatte (920) elektrisch verbunden sind.

6. Leiterplattenanordnung nach einem der Ansprüche 2 bis 5,
**dadurch gekennzeichnet,**
**dass** mittels des ersten Abstandsbolzens (730) und des zweiten Abstandsbolzens (740) gleichzeitig die Spannungsversorgung geführt und die Datenübertragungsverbindung hergestellt ist.

7. Leiterplattenanordnung nach einem der vorhergehenden Ansprüche,
**dadurch gekennzeichnet,**
**dass** mittels des ersten und des mindestens zweiten Abstandsbolzens die Signale CAN H und CAN L einer CAN-Bus Verbindung oder einer anderen seriellen Datenübertragungsverbindung zwischen der ersten und zweiten Leiterplatte übertragen werden, und/oder dass weitere Abstandsbolzen zur Signalübertragung anderer paralleler Datenübertragungsverbindungen vorhanden sind.

8. Leiterplattenanordnung nach einem der Ansprüche 1 bis 7,
**dadurch gekennzeichnet,**
**dass** mittels der Abstandsbolzen Feldbussignale, wie CAN-Bus Signale, Profibus Signale, Interbus-S Signale und/oder AS-Interface Signale, und/oder serielle Signale, wie RS232 Signale, I²C Signale, SPI Signale und/oder One-Wire Signale, und/oder parallele Signale, wie GPIO Signale und/oder einzelne Bits übertragen werden.

9. Leiterplattenanordnung nach einem der vorhergehenden Ansprüche,
**dadurch gekennzeichnet,**
**dass** mittels eines weiteren Abstandsbolzens oder mittels des ersten oder zweiten Abstandsbolzens die elektrische Masseverbindung zwischen der ersten und zweiten Leiterplatte geführt ist.

10. Leiterplattenanordnung nach einem der vorhergehenden Ansprüche,
**dadurch gekennzeichnet,**
**dass** mittels zumindest eines weiteren Abstandsbolzens die Versorgungsspannung zwischen der ersten und zweiten Leiterplatte geführt ist.
